## Europäisches Patentamt

## European Patent Office

## Office européen des brevets

(19)

(11) Numéro de publication: **0 196 933**
**B1**

(12)

(45) Date de publication du fascicule du brevet:
**13.09.89**

(51) Int. Cl.⁴: **G02B 6/28**, G02B 5/18,
**H04B 9/00**

(21) Numéro de dépôt: **86400380.1**

(22) Date de dépôt: **21.02.86**

(54) Dispositif d'interconnexion optique de cartes de composants électroniques dans un coffret et procédé de fabrication.

(30) Priorité: **26.02.85 FR 8502767**

(43) Date de publication de la demande:
**08.10.86 Bulletin 86/41**

(45) Mention de la délivrance du brevet:
**13.09.89 Bulletin 89/37**

(84) Etats contractants désignés:
**DE GB IT NL SE**

(73) Titulaire: **THOMSON-CSF, 51, Esplanade du Général de Gaulle, F-92800 Puteaux(FR)**

(72) Inventeur: **D'Auria, Luigi, THOMSON-CSF SCPI 173, Boulevard Haussmann, F-75379 Paris Cedex 08(FR)**
Inventeur: **Huignard, Jean-Pierre, THOMSON-CSF SCPI 173, Boulevard Haussmann, F-75379 Paris Cedex 08(FR)**
Inventeur: **Puech, Claude, THOMSON-CSF SCPI 173, Boulevard Haussmann, F-75379 Paris Cedex 08(FR)**
Inventeur: **Herriau, Jean-Pierre, THOMSON-CSF SCPI 173, Boulevard Haussmann, F-75379 Paris Cedex 08(FR)**

(74) Mandataire: **Lepercque, Jean et al, THOMSON-CSF SCPI, F-92045 PARIS LA DEFENSE CEDEX 67(FR)**

(56) Documents cités:
EP-A- 0 092 395
WO-A-85/03179
US-A- 4 063 083
US-A- 4 310 216
US-A- 4 447 118

IBM TECHNICAL DISCLOSURE BULLETIN,
vol. 26, no. 4, septembre 1983, pages 1793-1796, New York, US; L. BALLIET et al.: "Optical transmission system for interconnecting electronic units"
APPLIED OPTICS,
vol. 22, no. 6, 15 mars 1983, pages 891-900, Optical Society of America, New York, US; W.B. VELDKAMP: "Holographic local-oscillator beam multiplexing for array heterodyne detection"
PROCEEDINGS OF THE SOCIETY OF PHOTO-OPTICAL INSTRUMENTATION ENGINEERS, Periodic structures, gratings, moiré patterns, and diffraction phenomena, San Diego, US, 29 juillet

(56) Documents cités: (suite)
- 1 août 1980, vol. 240, pages 5-12, The Society of Photo-Optical Instrumentation Engineers, Bellingham, Washington, US; J.J. COWAN: "Blazed holographic gratings - formation by surface waves and replication by metal electroforming"
APPLIED OPTICS,
vol. 23, no. 17, 1 septembre 1984, pages 3004-3009, Optical Society of America, New York, US; J.-M.P. DELAVAUX et al.: "Design and fabrication of efficient diffraction transmission gratings on step-index optical waveguides"
PATENTS ABSTRACTS OF JAPAN, vol. 7, no. 123 (E-178) [1268], 27 mai 1983, Page 126 E 178 & JP - A - 58 42 333
PATENTS ABSTRACTS OF JAPAN, vol. 8, no . 250 (E-279) [1687], 16 novembre 1984, page 55 E 279 & JP - A - 59 126 339

ACTORUM AG

## Description

La présente invention se rapporte à un dispositif d'interconnexion optique entre des cartes de composants disposées dans un coffret d'un appareillage électronique.

Il est usuel dans un appareillage électronique de réaliser celui-ci à l'aide de cartes sur lesquelles sont montés des composants électroniques reliés entre eux par des pistes en circuits imprimés. Lorsque l'on utilise plusieurs cartes, celles-ci sont généralement enfichées côte à côte dans des coffrets métalliques appelés "paniers", avec leurs faces parallèles les unes aux autres. Le fond du panier est muni d'un ensemble de connecteurs électriques multicontacts sur lesquels se raccordent les cartes, et ces connecteurs sont réunis par un ensemble de liaisons. Les cartes sont alors guidées et maintenues par des rails fixés sur des parois du panier et vont s'enficher sur les connecteurs électriques multicontacts. Dans certains cas, on peut établir les liaisons entre les connecteurs à l'aide d'une carte mère formée avec un circuit imprimé, mais il est souvent nécessaire d'établir des liaisons filaires en raison de leur nombre et leur imbrication. Ces connecteurs de fond de panier ne suffisent pas toujours, et on est souvent amené à utiliser des connecteurs complémentaires en face avant, voire même parfois sur les faces des cartes. Ces connecteurs complémentaires sont alors reliés par des conducteurs rassemblés en câbles pour faciliter l'extraction des cartes. Il est donc tout à fait souhaitable de limiter au maximum le nombre de liaisons passant par les divers connecteurs. Cela est encore plus vrai pour les liaisons à fort débit qui nécessitent des précautions particulières, telles que des liaisons par câble coaxial, qui sont très délicates à mettre en oeuvre dans un tel environnement.

Aussi, il a été proposé de recourir, en particulier pour les liaisons à fort débit, à des liaisons supplémentaires par voie optique.

Dans l'Art Connu, ces liaisons par voies optiques ont été réalisées selon deux approches principales.

Selon une première approche, une fibre optique est utilisée comme canal de liaison entre deux cartes. Une des extrémités est couplée optiquement à une source émettrice de lumière, modulée par des informations à transmettre. L'autre extrémité de la fibre optique est couplée à un détecteur de lumière, convertissant celle-ci en signaux électriques. La source et le détecteur sont naturellement disposés sur deux cartes différentes entre lesquelles la liaison optique doit être établie.

Il faut donc disposer d'embases émettrices et réceptrices, de connecteurs ou organes analogues adaptés à une implantation sur une carte de circuit imprimé.

Une telle disposition est décrite, par exemple, dans la demande de brevet français FR-A 2 435 057.

Cette disposition ne pallie pas les inconvénients évoqués, c'est-à-dire la multiplication de nappes ou câbles de liaisons physiques, en face avant ou arrière des cartes.

Selon une autre approche, il a été proposé des liaisons optiques mettant en oeuvre des guides de lumière, constitués par au moins une lame à faces parallèles, en matériau transparent, et comportant des éléments réflecteurs disposés sur ses deux faces. Un dispositif optique intérieur à la lame permet d'introduire dans le guide un faisceau de lumière dont l'axe est perpendiculaire au plan de la lame, et qui est émis par un dispositif émetteur situé sur une première carte. Un autre dispositif optique intérieur à la lame et semblable au précédent, permet d'extraire un faisceau de la lame, pour le dévier vers un dispositif récepteur de lumière situé sur une seconde carte. Le document IBM Technical Disclosure Bulletin vol.26 n°4 September 1983 décrit un dispositif de ce type, dans lequel les dispositifs optiques intérieurs à la lame sont constitués chacun d'un cône qui réfléchit dans toutes les directions parallèles au plan de la lame. Ce dispositif d'interconnexion optique a pour inconvénients de nécessiter une lame guide de lumière pour chaque émetteur de lumière, puisque chaque cône réfléchit dans toutes les directions ; et d'être difficile à fabriquer puisqu'il faut réaliser des dispositifs optiques à l'intérieur des guides d'onde.

Le document WO 85/03179, qui est cité au titre de l'article 54(3) de la CBE, pour apprécier seulement la nouveauté de l'invention, décrit un dispositif d'interconnexion optique comportant : une lame à faces parallèles en matériau transparent: des éléments réflecteurs disposés sur les deux faces de la lame; et des dispositifs diffractants intérieurs à la lame. Ces dispositifs diffractants ont un effet directif permettant d'utiliser une même lame pour plusieurs liaisons indépendantes, mais ils sont difficiles à réaliser car situés à l'intérieur de la lame.

L'invention vise à pallier les inconvénients de l'Art Connu et propose un dispositif d'interconnexion optique permettant d'établir des voies de communications multiples entre deux cartes quelconques ou plus, d'un même panier en évitant l'encombrement et la complexité des liaisons par fibres optiques, et en évitant la difficulté de fabrication d'éléments diffractants situés à l'intérieur d'un guide de lumière.

L'invention a donc pour objet un dispositif d'interconnexion optique pour un boîtier contenant des cartes de composants électroniques placées côte à côte, le dispositif permettant d'établir au moins une liaison par voie optique entre une première carte sur laquelle est implantée une source de lumière, émettant un faisceau divergent suivant une première direction de propagation moyenne et une seconde carte sur laquelle est implanté un détecteur de lumière, comportant une lame à faces parallèles, en matériau transparent à ladite lumière, placée au regard de la source de lumière, et des éléments réflecteurs disposés sur les deux faces de la lame, caractérisé en ce qu'il comporte en outre les éléments optiques suivants : un premier élément optique à structure diffractante sur une première face de la lame, opposée à la source de lumière, captant le faisceau divergent et le réfléchissant sous la forme d'au moins un faisceau collimaté, de direction de propagation formant un angle déterminé avec les faces de la lame, des éléments réflecteurs disposés sur les deux faces de la lame, captant et réfléchissant le faisceau collimaté et un deuxième élément optique à structure diffractante disposé sur la première face de la lame, captant après des réflexions successives à l'intérieur de la lame, sur les éléments réflecteurs, le faisceau collimaté et le réfléchissant sous la forme d'un faisceau convergent suivant une deuxième direction de propagation moyenne, ce faisceau étant capté par ledit détecteur de lumière implanté sur la seconde carte, de manière à former un chemin optique continu entre lesdites première et seconde cartes du boîtier.

L'invention a encore pour objet un procédé de fabrication d'un tel dispositif.

L'invention sera mieux comprise et d'autres particularités et avantages apparaîtront à la lecture de la description qui suit en regard des figures annexées et parmi lesquelles :

- la figure 1 illustre schématiquement un appareillage électronique incorporant un dispositif d'interconnexion optique selon l'invention ;
- la figure 2 est un détail agrandi du dispositif de l'invention ;
- les figures 3 à 8 illustrent schématiquement des éléments optiques à structure diffractante utilisés par l'invention, selon plusieurs variantes d'exécution ;
- la figure 9 représente un exemple de configuration d'un réseau complet d'interconnexions optiques selon l'invention ;

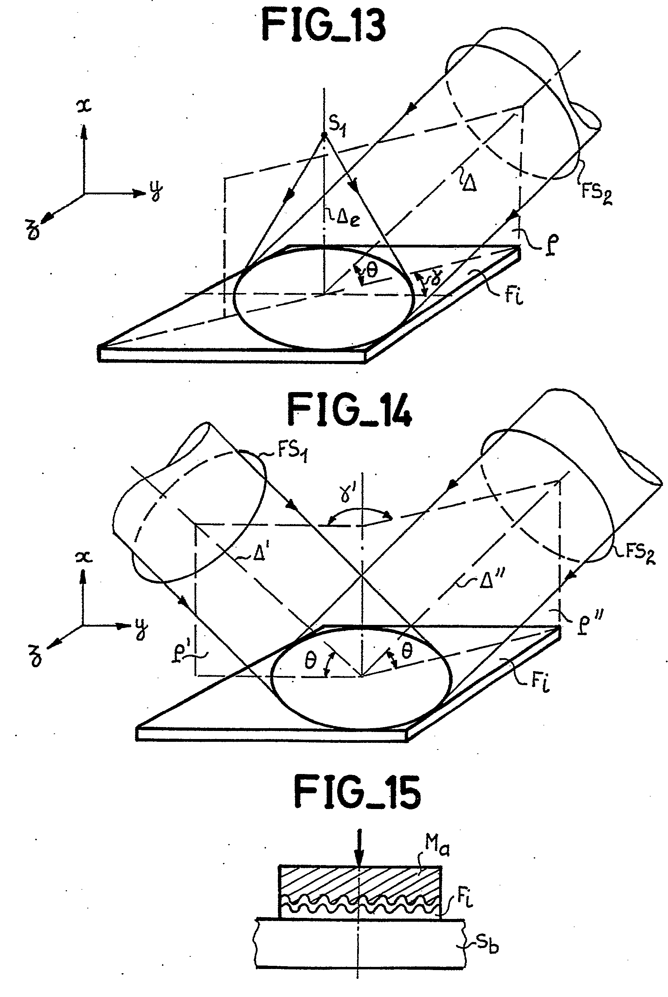

- les figures 10 à 14 représentent des étapes du procédé de fabrication d'éléments optiques à structure diffractante selon une première variante de réalisation ;
- la figure 15 représente une étape particulière du procédé de fabrication d'éléments optiques à structure diffractante selon une deuxième variante de réalisation.

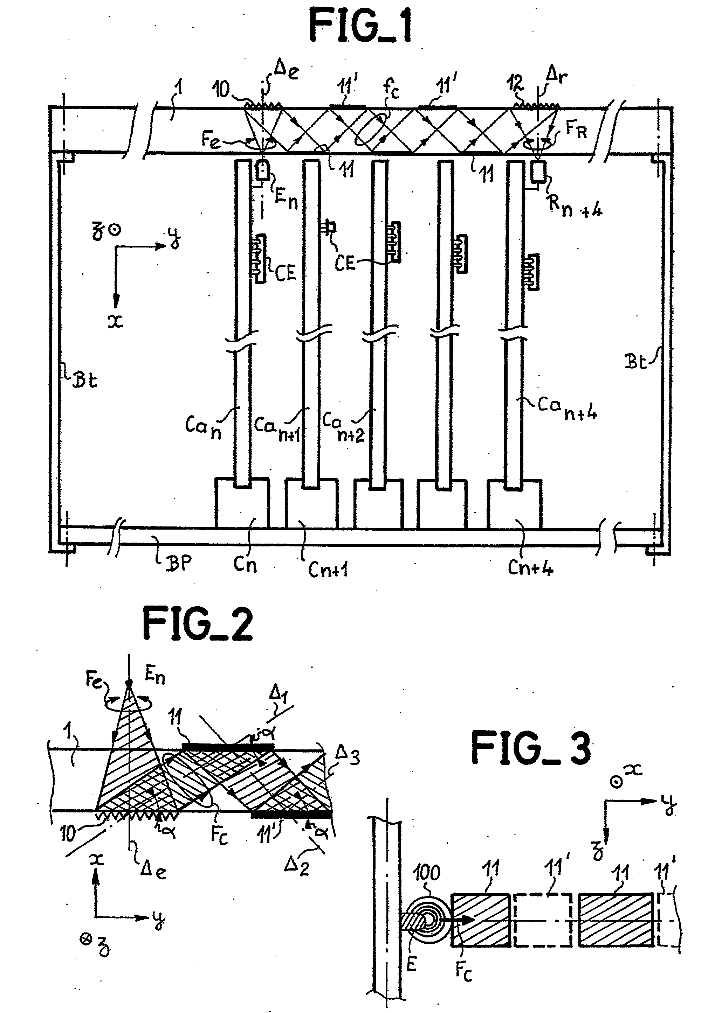

La figure 1 illustre schématiquement un appareillage électronique incorporant le dispositif de l'invention.

De façon classique, cet appareillage est constitués d'un ensemble de cartes à circuits imprimés, $Ca_n$ à $Ca_{n+4}$, sur lesquels sont implantés divers composants électroniques CE. Ces cartes sont enfichées dans des connecteurs électriques multicontacts, $C_n$ à $C_{n+4}$, dits de "fond de panier". Ces connecteurs sont eux-mêmes solidaires d'une carte mère BP, appelée couramment "back-panel" selon la terminologie anglo-saxonne. Il s'agit en général d'une carte à circuits imprimés et établissant des liaisons par voie électrique entre les différentes cartes $Ca_n$ à $Ca_{n+4}$. l'ensemble est disposé dans un boîtier métallique Bt ou "panier", comportant des glissières pour les cartes, non représentées sur la figure 1.

Le dispositif selon l'invention qui permet d'établir des liaisons par voie optique comprend une plaque 1 constituée d'une lame à faces parallèles, en matériau transparent aux longueurs d'ondes utilisées pour établir lesdites liaisons optiques. Cette plaque est disposée perpendiculairement aux plans des cartes, $Ca_n$ à $Ca_{n+4}$, à circuits imprimés dans l'exemple illustré. Cette plaque 1 est disposée en face avant et forme le panneau avant du boîtier Bt, sans que cela soit limitatif de l'invention.

On supposera dans ce qui suit que les cartes, $Ca_n$ à $Ca_{n+4}$, sont disposées parallèlement à un plan zx d'un trièdre orthonomé xyz. La plaque 1 a donc ses faces principales parallèles au plan yz de ce trièdre.

Si l'on désire établir une liaison optique entre deux cartes quelconques du boîtier Bt, par exemple sur la figure 1, entre les cartes $C_n$ et $C_{n+4}$, on dispose, en regard de la plaque 1, un émetteur de lumière $E_n$ sur une première carte, $Ca_n$, et un détecteur de lumière $R_{n+4}$, sur une seconde carte, $Ca_{n+4}$. On admet, dans l'exemple illustré, qu'il s'agit d'une liaison optique unidirectionnelle dans le sens : carte $Ca_n$ à carte $Ca_{n+4}$.

Pour réaliser la liaison optique selon l'invention, on dispose en regard de la source émettrice de lumière $E_n$, par exemple une diode laser ou une diode électroluminescente, et sur la face opposée de la plaque 1, c'est-à-dire la face extérieure sur la figure 1, un élément optique 10 constitué par une structure diffractante à réseau optique.

La source de lumière $E_n$ émet un faisceau divergent $F_e$ suivant une direction moyenne de propagation $\Delta_e$ perpendiculaire aux faces parallèles de la lame 1, c'est-à-dire parallèlement à l'axe x.

La fonction de cet élément optique est de réfléchir le faisceau incident en le transformant en un faisceau collimaté $F_c$.

La figure 2 représente un détail agrandi du dispositif selon l'invention.

L'élément optique 10 réfléchit donc le faisceau incident, en le transformant en un faisceau collimaté $F_c$, suivant une direction de propagation moyenne $\Delta_1$ formant un angle $\alpha$ avec les faces parallèles de la lame 1, direction $\Delta_1$ comprise dans un plan parallèle au plan xy, ou encore perpendiculaire aux cartes. De façon préférentielle, on choisit l'angle $\alpha$ égal à

$\frac{\pi}{4}$ radian.

Selon un autre aspect de l'invention, on dispose sur les deux faces de la lame 1, en alternance, des éléments réflecteurs 11 et 11', interceptant les rayons réfléchis par l'élément optique 10 à structure réfractante et réfléchissant à leur tour les rayons suivant des directions $\Delta_2$ et $\Delta_3$ sur la figure 2, formant également des angles égaux, en valeur absolue, à l'angle avec les faces parallèles de la lame 1. Cet ensemble d'éléments optiques réfléchissants établissent donc, de proche en proche, une liaison optique de la carte $Ca_n$ (figure 1) à la carte $Ca_{n+4}$. Dans ce qui suit l'élément optique 10 sera appelé élément optique émetteur.

Un deuxième élément optique 12 à structure diffractante est disposé en regard du récepteur $R_{n+4}$, qui peut être, par exemple, une diode de type PIN. Cette diode est disposée sur la face extérieure de la lame 1. Sa fonction est inverse de celle de l'élément optique 10. L'élément optique 12, que l'on appelera dans ce qui suit élément optique récepteur, capte le faisceau collimaté réfléchi par le dernier élément réflecteur 11, élément disposé sur la face interne de la lame 1, sous une incidence α, le convertit en un faisceau convergent $F_R$, transmis suivant une direction moyenne de propagation $\Delta r$ perpendiculaire aux faces de la lame 1, c'est-à-dire parallèle à l'axe x. Le détecteur $R_{n+4}$ capte ces rayons et les convertit en un signal électrique. On établit bien, par le dispositif de l'invention, une liaison optique entre deux cartes quelconques du boîtier Bt, liaison dans l'exemple illustré de direction orthogonale aux plans des cartes à circuits imprimés.

Il est à noter que si les émetteur $E_n$ et récepteur $R_{n+4}$ ont leurs faces actives, respectivement d'émission et de réception, éloignées de la même distance de la face externe de la lame 1, les éléments 10 et 12 ont dans la réalité une configuration analogue. La manière de réaliser ces éléments sera décrite de façon détaillée ultérieurement.

Selon un aspect supplémentaire de l'invention, les éléments optiques émetteurs et récepteurs peuvent prendre plusieurs configurations.

Suivant une première configuration, illustrée par la figure 3 en ce qui concerne l'élément optique émetteur, si une source émettrice de lumière E, émet suivant une direction moyenne de propagation parallèle à l'axe x, l'élément optique émetteur repéré 100 sur la figure 3, réfléchit et transforme le faisceau incident en un faisceau collimaté $F_c$ de direction moyenne de propagation comprise dans un plan perpendiculaire aux cartes, soit un plan parallèle au plan x y ou encore aux faces principales de la lame 1. Dans l'exemple illustré sur la figure 3, la propagation s'effectue de la gauche vers la droite, le faisceau subissant des réflexions multiples du fait des éléments réflecteurs alternés 11 et 11'. Ce premier type d'élément optique émetteur est d'ailleurs identique à celui illustré sur la figure 1. Par rotation de π radians, un élément similaire "émettrait" un faisceau collimaté, toujours parallèlement à l'axe y mais en sens opposé à ce qui est illustré par la figure 3.

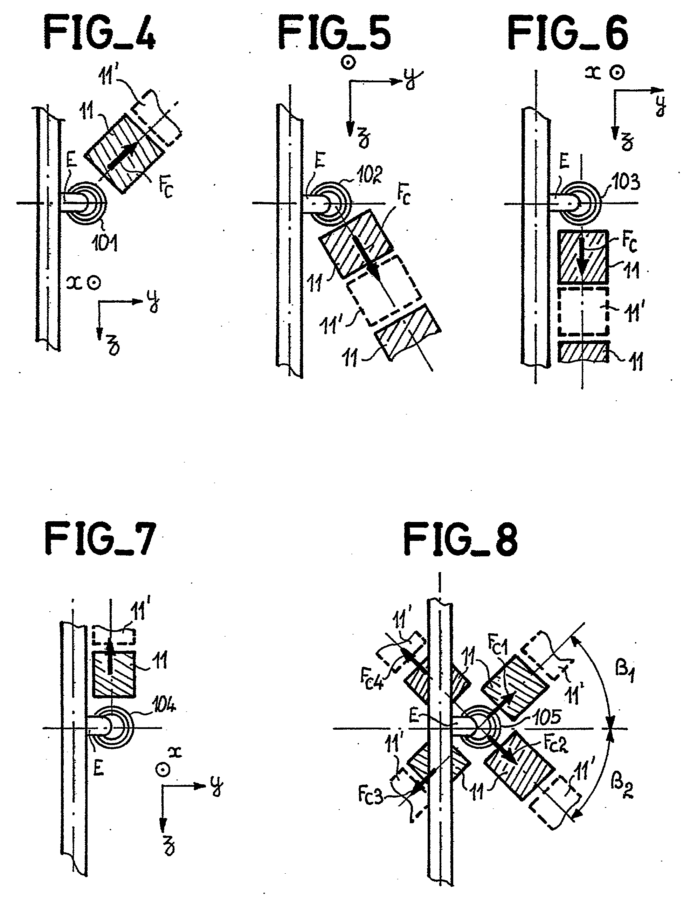

Il en est naturellement de même en ce qui concerne les éléments optiques récepteurs (Fig. 1 : 12). Dans les configurations qui vont être décrites dans ce qui suit en relation avec les figures 4 à 8, ces éléments ne seront plus mentionnés explicitement, étant bien entendu que ces configurations s'appliquent également à ces éléments.

Les figures 4 à 7 illustrent quatre autres configurations particulières, parmi celles possibles, d'éléments émetteurs, repérés 101 à 104.

Par analogie à la configuration qui vient d'être décrite et qui permet d'établir une liaison optique suivant une direction perpendiculaire aux plans des cartes à circuits imprimés, on obtient des émetteurs à "$\frac{\pi}{4}$ radians, gauche" (figure 4 : 101) ; "$\frac{\pi}{4}$ radians, droit" (figure 5 : 102) ; "$\frac{\pi}{2}$ radians, gauche" (figure 5 : 107) ; et "$\frac{\pi}{2}$ radians, droit" (figure 7 : 104).

Ces configurations sont les plus simples : angles

multiples entiers de $\frac{\pi}{4}$ radians , une seule direction et un seul sens privilégiés de réflexion.

On peut cependant réaliser des configurations plus complexes réfléchissant dans deux ou plus directions privilégiées différentes.

A titre d'exemple parmi d'autres, la figure 8 illustre un exemple d'élément 105, permettant d'établir à partir d'une seule source émettrice de lumière E, quatre liaisons distinctes. Dans l'exemple de la figure 8, les liaisons optiques s'effectuent suivant des directions formant des angles $\beta_1$ et $\beta_2$ avec un plan orthogonal aux cartes à circuits imprimés. Ces angles sont égaux à $\frac{\pi}{4}$ radians dans l'exemple illustré par la figure 8.

En mettant en œuvre des éléments optiques à structure diffractante, selon plusieurs configurations, on peut réaliser un réseau complexe d'interconnexions optiques entre cartes d'un même boîtier.

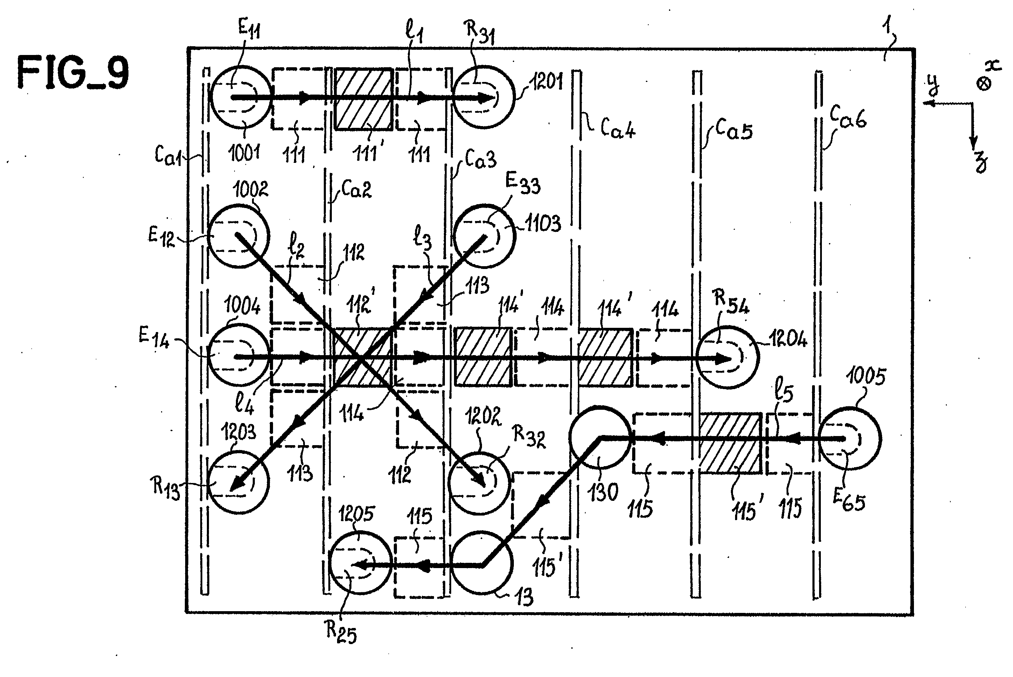

La figure 9 illustre schématiquement un exemple d'un tel réseau de liaisons par voie optique.

Dans un but de clarté, on a limité à six le nombre total de cartes à circuits imprimés : $Ca_1$ à $Ca_6$. En outre, les connecteurs électriques, la carte les supportant ainsi que le boîtier n'ont pas été représentés.

Les liaisons sont représentées au nombre de cinq et illustrent quelques unes des possibilités offertes par le dispositif de l'invention.

Cette figure représente une vue avant de la lame 1.

Une première liaison $l_1$ par voie optique relie la carte $Ca_1$ à la carte $Ca_3$ par une source émettrice de lumière $E_{11}$ couplée optiquement à un élément optique émetteur 1001 disposé sur la face avant de la lame 1, des éléments réflecteurs 111 et 111' disposés alternativement sur les faces avant et arrière de la lame 1 et un élément optique récepteur 1201 disposé sur la face avant de la lame 1 et couplé optiquement à un détecteur de lumière $R_{31}$. La liaison $l_1$ s'effectue suivant une direction de propagation orthogonale aux plans des cartes $Ca_1$ à $Ca_6$.

De façon similaire, des liaisons diagonales $l_2$ et $l_3$, inclinées à $\frac{\pi}{4}$ radians, sont réalisées, d'une part entre les cartes $Ca_1$ et $Ca_3$ et, inversement, entre les cartes $Ca_3$ et $Ca_1$, d'autre part.

La liaison $l_2$ est réalisée à l'aide des composants suivants : source de lumière $E_{12}$, élément optique émetteur 1102 à $\frac{\pi}{4}$ radians , éléments optiques réflecteurs 112 et 112', élément optique récepteur 1202 à $5\frac{\pi}{4}$ radians et détecteur de lumière $R_{32}$.

La liaison $L_3$ est réalisée à l'aide des composants suivants : source de lumière $E_{33}$, élément optique émetteur 1103 à $3\frac{\pi}{4}$ radians, éléments optiques réflecteurs 113 et 112', élément optique récepteur 1203 à $-\frac{\pi}{4}$ radians et détecteur de lumière $R_{32}$.

Une liaison l$_4$ suivant une direction orthogonale aux plans des cartes est réalisée entre la carte Ca$_1$ et la carte Ca$_5$ et met en oeuvre une source de lumière E$_{14}$, un élément optique émetteur 1004, des éléments réflecteurs alternés 114, 114', et 112', un élément optique récepteur 1204 et un détecteur de lumière R$_{54}$.

Il est à noter que l'élément réflecteur 112' est commun aux trois liaisons l$_2$ à l$_4$. Cela ne pose aucun problème de diaphonie du fait des propriétés de directivité associées éléments optiques émetteurs et récepteurs.

Enfin, il est établi une liaison par voie optique entre la carte Ca$_6$ et la carte Ca$_2$. Cette liaison est plus complexe que les liaisons l$_1$ à l$_4$ précédemment décrites.

En effet, selon un aspect avantageux de l'invention, il est mis en œuvre des éléments optiques à structure diffractante d'un troisième type .

Il s'agit d'éléments intermédiaires permettant des changements de direction de propagation des faisceaux collimatés.

Contrairement aux éléments optiques émetteurs et récepteurs, la fonction de ces éléments est de réfléchir un faisceau collimaté, sans en changer la nature, mais en en changeant la direction de propagation. Par direction de propagation, dans le cadre de l'invention, il faut naturellement entendre la projection dans le plan yz, c'est-à-dire dans un plan parallèle au faces de la lame 1.

Si l'on se reporte de nouveau à la figure 9, la source de lumière E$_{65}$ émet un faisceau divergent suivant une direction de propagation moyenne parallèle à l'axe x, l'élément optique émetteur 1005 le transforme en un faisceau collimaté vers un élément optique 130, disposé au niveau de la carte Ca$_4$, après des réflexions alternées sur des éléments réfléchissants 115 et 115'.

Cet élément infléchit la direction de propagation de $\dfrac{5\pi}{4}$ radians vers un élément optique 131, du même type après une réflexion intermédiaire sur un élément réflecteur 115'. Le faisceau en aval de l'élément 130, subit également une réflexion intermédiaire sur un élément réfléchissant 115 disposé sur la face arrière de la lame 1.

L'élément 131 infléchit à nouveau la direction de propagation de $\dfrac{+\pi}{4}$ radians vers un élément optique récepteur 1205 via un élément réflecteur 115 disposé également sur la face arrière de la lame 1. La liaison l$_5$ par voie optique entre les cartes Ca$_6$ et Ca$_2$ est ainsi complétée. On remarque que les éléments optiques à structure diffractante du troisième type, 130 et 131 sur la figure 9, prennent simplement la place d'un élément réflecteur sur la face appropriée, la lame 1 de manière à respecter l'alternance.

Dans ce qui suit, on appelera ces éléments, éléments optiques de changement de direction de propagation.

Sur la figure 9, les éléments 130 et 131 sont disposés sur la seule face avant, mais il aurait pu en être autrement.

De façon analogue à ce qui a été décrit en relation avec les figure 3 à 8, les éléments de changement de direction de propagation, peuvent prendre différentes configurations. La seule différence est qu'ils ne transforment pas un faisceau collimaté incident en un faisceau convergent comme le font les éléments optiques récepteurs.

On réalise aisément que la mise en oeuvre des éléments optiques à structure diffractante selon plusieurs variantes et d'éléments réflecteurs, en association avec des sources émettrices de lumière et des détecteurs de lumière permet de réaliser simplement un réseau complexe d'interconnexions optiques, entre des cartes quelconques d'un même boîtier.

En résumé, une liaison par voie optique entre source de lumière et un détecteur de lumière selon l'invention, nécessite au moins la mise en oeuvre d'un élément optique émetteur, d'un élément optique récepteur et d'éléments réflecteurs alternés. Optionnellement, on peut également utiliser un ou plusieurs éléments optiques de changement de direction de propagation, tels que les élément 130 et 131.

Aucune de ces liaisons ne nécessite ni éléments coûteux et complexes tels que des connecteurs optiques, ni fibres optiques.

La précision exigée dans le positionnement de ces éléments n'est pas non plus aussi critique que celle exigée pour la réalisation de liaisons à l'aide de connecteurs optiques et de fibres optiques.

Dans une application typique, un coffret renferme quinze cartes environ dont la hauteur est de l'ordre de 15 cm. Elles sont disposées parallèlement les unes aux autres enfichées dans des connecteurs de fond de panier au pas de 2 cm.

On peut donc disposer raisonnablement de quinze composants sources ou détecteurs de lumière au pas de 1 cm, sur chaque carte.

Dans ces conditions, chaque motif élémentaire occupe typiquement une zone dont la surface est inscrite dans un carré de 1 cm x 1 cm.

Bien que représentés sur les figures sous la forme de plages rectangulaires, les éléments réflecteurs peuvent présenter toute forme appropriée. On peut également recourir à une métallisation uniforme des deux faces de la lame 1, à l'exception des zones réservées aux éléments optiques à structures diffractantes.

Le procédé de fabrication du dispositif selon l'invention va maintenant être explicité.

Le procédé de fabrication comprend, comme il vient d'être indiqué, une phase de métallisation sélective des deux faces principales de la lame 1. Cette étape ne pose pas de problèmes particuliers. Toute technique appropriée de l'Art Connu peut être mise en oeuvre. Le dépôt sélectif est obtenu par masquage.

La nature du métal n'est pas non plus critique. On peut utiliser par exemple de l'argent. L'épaisseur du dépôt est typiquement dans la gamme mille à quelques milliers d'Angströms.

Le substrat, c'est-à-dire la lame 1 à faces parallèles, peut être en verre, en plastique ou plus généralement en tout matériau transparent aux longueurs d'ondes utilisées.

Le procédé de fabrication comprend également des étapes d'obtention des structures diffractantes.

Il s'agit de créer des réseaux optiques ayant des propriétés bien définies pour obtenir les diverses configurations décrites.

Pour ce faire, selon un mode de réalisation préféré, on recourt à une technique d'enregistrement holographique. Comme il est bien connu, si l'on fait interférer dans un milieu photosensible deux ondes issues de sources de lumière cohérente, on obtient des figures d'interférences. Ces deux ondes peuvent d'ailleurs être issues de la même source, par utilisation d'un diviseur de faisceau.

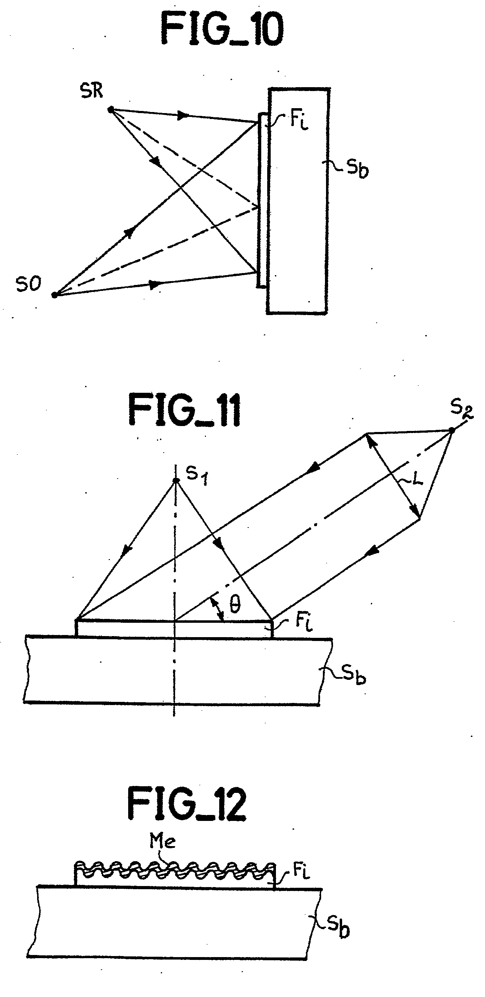

La figure 10 illustre schématiquement le processus de formation d'un hologramme dans un film photosensible $F_i$, supporté par un substrat. On éclaire ce film par des faisceaux issus d'une source objet SO et une source de référence SR, sous des incidences déterminées.

Pour obtenir un hologramme définitif, il faut procéder à une étape de développement, éventuellement suivie d'une étape de fixage, étapes qui s'apparentent à celles mises en oeuvre en photographie classique.

A titre d'exemple dans le cadre de l'invention, on peut utiliser comme matériau photosensible de la gélatine bichromatée ou un photorésist.

Dans le premier cas, le développement est effectué à l'aide d'une solution d'alcool dans de l'eau et le fixage est obtenu par encapsulation, ce matériau étant fortement hydrophile.

Dans le second cas, le développement est effectué à l'aide de produits disponibles dans le commerce, adaptés au photoresist particulier. Habituellement, le fixage est obtenu par recuit.

Une fois stabilisé, la structure diffractante ainsi obtenue peut être "relue". On éclaire cette structuree par un faisceau ayant les mêmes caractéristiques que le faisceau de référence.

Il existe deux types de réseaux selon que les faisceaux d'écriture éclairent le film d'un même côté, comme illustré sur la figure 10, ou par les deux faces principales. On obtient alors respectivement, des réseaux en transmission et des réseaux en réflexion.

Dans le premier cas, réseaux en transmission, le pas $\Lambda$ de ces réseaux est typiquement compris entre 0,5 et quelques micromètres. Dans le second cas, réseaux en réflexion, le pas $\Lambda$ est typiquement compris entre 0,1 et 0,3 micromètre. Ce dernier type de réseau est donc plus difficile à réaliser.

Aussi, dans le cadre de l'invention, de façon préférentielle, bien que le produit final doit être une structure réfléchissante, on créé, dans une première étape, un réseau du type en transmission et on rend réfléchissant ce réseau, dans une deuxième étape, en le métallisant.

La réalisation d'un réseau, selon l'invention, peut s'effectuer selon deux variantes principales.

Selon une première variante, illustrée par les figures 11 et 12, on procède à la réalisation directe de la structure diffractante sur un film photosensible $F_i$.

Une première étape, illustrée par le figure 11, consiste en la génération d'une figure de diffraction particulière en éclairant le film à l'aide de deux faisceaux comme il a été indiqué en relation avec la figure 10. Pour réaliser des structures diffractantes selon l'invention, il faut que l'un des faisceaux soit un faisceau divergent, c'est-à-dire une onde sphérique, et l'autre un faisceau collimaté, c'est-à-dire une onde plane, du moins en ce qui concerne les éléments optiques de types émetteurs et récepteurs.

Il faut en outre que des conditions d'incidences particulières soient respectées pour obtenir diverses configurations, comme il est décrit en relation avec les figures 3 à 7.

Une première source cohérente $S_1$, que l'on assimile à une source ponctuelle, éclaire le film avec une incidence moyenne normale au plan du film. La distance entre la source $S_1$ et le film doit être égale à la distance séparant les sources de lumière disposées sur les cartes à circuits imprimés (figure 1 : $E_n$) de la face externe de la lame 1, sur laquelle est disposé l'élément émetteur (figure 1 : 10). Cette distance est en général peu différente de l'épaisseur de la lame.

Une deuxième source cohérente $S_2$, associée par exemple à une lentille collimatrice, L éclaire le film, par un faisceau de rayons parallèles, sous une incidence égale à un angle $\theta$.

L'étape d'éclairement est suivie d'étapes de développement et de fixage de l'hologramme créé dans le film $F_i$, de façon classique.

Le réseau optique obtenu se présente sous la forme d'un film comportant des microreliefs sur sa face externe.

Pour rendre ce réseau réfléchissant, il est nécessaire de procéder, comme illustré par la figure 12, à une métallisation de cette face externe. On dépose, par tout procédé approprié, une couche de métal $M_e$, typiquement dans la gamme d'épaisseurs mille à quelques milliers d'Angströms. Le métal utilisé peut être, par exemple, de l'argent, de l'or ou du cuivre.

Si le réseau ainsi obtenu est éclairé, par sa face interne, par une source reproduisant les caractéristiques de la source $S_1$, il transforme le faisceau divergent d'éclairement en un faisceau collimaté réfléchi dont la direction de propagation forme un angle $\theta$ avec la face interne du film $F_i$.

Si l'on se reporte à nouveau à la figure 2, il suffit de choisir l'angle $\theta$ égal à l'angle $\alpha$ pour se trouver dans les conditions de fonctionnement de l'élément optique émetteur 10.

Par analogie, ceci est également vrai pour les éléments optiques récepteurs (par exemple figure 1 : 12). Si l'on éclaire le réseau par sa face interne, par un faisceau collimaté d'incidence $\theta$, ce faiseau est réfléchi et transformé en un faisceau convergent de direction de propagation moyenne normale à la face interne du réseau.

De façon préférentielle, l'angle $\theta$ est choisi égal à $\frac{\pi}{4}$ radians.

On réalise aisément que l'on peut obtenir différentes configurations d'éléments optiques émetteurs ou récepteurs, notamment les configurations explicitées en relation avec les figures 3 à 8.

La figure 13 explicite la façon de procéder. On suppose que le film photosensible $F_i$ est de forme carrée ou rectangulaire, les côtés étant parallèles à deux axes z et y d'un trièdre orthonormé x y z, et que les cartes à circuits imprimés disposées dans le boîtier (figure 1 : BL) ont leurs faces principales parallèles au plan xz.

Si l'on désire obtenir des liaisons suivant des directions autres que la normale aux faces principales de ces cartes, il suffit d'ajuster en conséquence la direction de propagation moyenne du faisceau collimaté.

Si $\Delta$ est l'axe optique du faisceau collimaté $FS_2$ produit par la source $S_2$ (non représentée sur la figure 13), celui-ci est compris dans un plan P orthogonal aux faces principales du film $F_i$, c'est-à-dire orthogonal au plan zy.

Pour obtenir une direction privilégiée de propagation en réflexion, il suffit d'ajuster l'angle $\gamma$, angle que forment le plan P et le plan xy, à une valeur déterminée, par exemple $+\dfrac{\pi}{4}$ radians.

Lorsque l'on désire plusieurs directions privilégiées, par exemple quatre directions comme dans le cas de la configuration de la figure 8, il faut enregistrer autant d'hologrammes différents dans le film $F_i$.

Ceci peut être réalisé simplement en opérant plusieurs expositions, par exemple en faisant tourner le plan P autour d'un axe $\Delta_e$, direction moyenne d'émission de la source $S_1$ ; cet axe restant naturellement normal à la surface du film $F_i$ et la source $S_1$ restant fixe. Pour ce faire, soit on peut déplacer la source $S_2$ dans l'espace ou faire tourner le film $F_i$ autour de l'axe $\Delta_e$.

Dans le cas des éléments optiques de changement de direction de propagation tels que les éléments 130 et 131 de la figure 9, la nature des faisceaux d'éclairement et les conditions d'incidences sont naturellement différentes.

La figure 4 illustre cet exemple.

Il faut éclairer le film photosensible par deux faisceaux collimatés $FS_1$ et $FS_2$.

Les axes optiques $\Delta$ et $\Delta''$ de ces faisceaux ont une incidence commune égale à l'angle $\theta$ précité. Ces axes sont contenus respectivement dans des plans P' et P'', orthogonaux aux plans principaux du film $F_i$ et formant entre eux un angle égal à $\gamma'$. Cet angle $\gamma'$ représente le changement de direction désiré.

En effet, en lecture, le réseau éclairé par un faisceau collimaté d'axe $\Delta'$, réfléchit celui-ci sous la forme d'un faisceau également collimaté, mais d'axe $\Delta''$ ; et inversement, le système optique ainsi formé étant réversible.

Dans le cadre de l'invention, on choisit $\gamma'$ préférentiellement égal à $\dfrac{\pm\pi}{4}$ ou $\dfrac{\pm\pi}{2}$ selon les changements de direction désirés.

Il a été supposé dans ce qui précède que la longueur d'onde utilisée en écriture et celle utilisée en lecture, c'est-à-dire, pour cette dernière, la longueur d'onde des sources de lumière implantées sur les cartes à circuits imprimés, sont identiques ou pour le moins très proches.

Ce n'est en général pas le cas. Dans une application préférée du dispositif de l'invention, les liaisons optiques mettent en oeuvre des diodes électroluminescentes émettant sur une longueur d'onde centrée sur la valeur 840 nanomètres. Or les matériaux photosensibles généralement utilisés présentent un maximum de sensibilité dans le spectre de longueurs d'ondes s'étalant de 450 à 550 nanomètres. Dans ce cas, la lecture et l'écriture doivent être réalisés sous des conditions d'incidences différentes. Ce phénomène est connu sous le nom d'effet Bragg. Le calcul permet d'effectuer les corrections voulues, tenant compte du déplacement en longueurs d'ondes.

On peut obtenir des efficacités de diffraction, après métallisation, supérieures à 50%.

Selon une seconde variante du procédé de fabrication, les structures diffractantes sont obtenues par pressage à partir d'une matrice.

Pour ce faire, on réalise des réseaux diffractants de façon analogue à ce qui a été indiqué en relation avec la figure 11 : éclairement, développement et fixage.

Le microrelief est ensuite transféré sur une matrice constituée d'une couche métallique, en nickel par exemple. Ce transfert peut s'effectuer par les techniques habituellement utilisées pour la duplication de disques optiques.

Ensuite, comme illustré par la figure 15, on procède à une étape de pressage. La matrice Ma, portant sur sa face inférieure le motif à dupliquer, est pressée contre un film $F_i$ en matériau malléable : matériau thermoplastique, polymère, etc...

Enfin, comme dans le cas de la première variante, on procède à une étape de métallisation du microrelief dupliqué comme illustré par la figure 12.

Cette variante du procédé de l'invention présente l'avantage de pouvoir réaliser sur la lame 1 tous les éléments diffractants nécessaires à un réseau complet d'interconnexions en une seule opération.

Comme l'ordre des phases du procédé : métallisation et création des structures diffractantes, n'est pas critique, cette variante présente l'avantage supplémentaire de pouvoir réaliser, également en une seule opération toutes les métallisations, que ce soit pour la création des éléments réflecteurs ou pour la métallisation des structures diffractantes. Il suffit, pour ce faire, de réaliser l'étape de métallisation en fin de processus.

La métallisation peut être uniforme. Il suffit de préserver, par masquage, les seules zones sous-jacentes aux éléments optiques émetteurs et récepteurs. En effet, ces zones doivent être transparentes pour laisser le passage aux rayonnements issus des sources de lumières ou transmis aux détecteurs.

Enfin, dans le cas où la lame 1 est en matériau plastique, la duplication des structures réfractantes peut être fait directement sur celle-ci pendant l'étape de pressage, sans utiliser de films intermédiaires qui doivent être disposés sur la lame.

Le procédé selon l'invention se prête donc particulièrement bien à une production en grande série, notamment pour des matériels dits "grand-public". Tout en autorisant les performances élevées des liaisons par voie optique, il en réduit fortement les coûts et la complexité.

Pour fixer les idées, un dispositif conforme à l'invention pourra présenter les caractéristiques techniques typiques suivantes :

Les sources de lumières peuvent être des diodes électroluminescentes semiconductrices émettant un spectre de radiations centré sur la longueur d'onde 840 nm et de largeur de bande environ 80 nm ($\pm$ 40 nm). La surface émissive est un quadrilatère rectangle dont les dimensions sont comprises dans la gamme 50 à 80 micromètre. Le courant injecté est d'environ 10 mA, la puissance optique émise est d'environ 100 microwatts.

Pour un taux d'erreurs inférieur à $10^{-10}$, à un débit binaire de l'ordre de 100 Mbit/s, le détecteur comprenant par exemple une photodiode semiconductrice de type PIN associée à un amplificateur de faible complexité, il est nécessaire d'assurer une puissance optique à détecter de l'ordre du microwatt.

Dans ces conditions, l'atténuation maximale entre source émettrice et détecteur est égale à 20 dB.

Pour une ouverture numérique égale à 0,5, on peut estimer les pertes de couplage entre la source de lumière et l'élément optique émetteur à 6 dB. Les pertes dues aux éléments réflecteurs sont de l'ordre de 0,1 dB. Les pertes de propagation peuvent être estimée être inférieurs à 0,01 dB et peuvent être négligées.

Il reste donc une marge de l'ordre de 10 dB. Cette marge permet de prendre en compte le rendement, inférieur à 100%, des structures diffractantes.

Afin d'accroître les tolérances mécaniques, il est avantageux de réduire autant que possible la surface émissive des sources et d'augmenter la surface active des détecteurs, sans que leur capacité électrique augmente dans de trop grandes proportions.

Avec l'ordre de grandeur de la surface émissive qui a été rappelée, pour une capacité électrique maximale de 1 pF, la photodiode peut avoir une surface de détection circulaire typique de diamètre égal à 500 micromètres.

Les tolérances de positionnement sur cartes à circuits imprimés peuvent être de l'ordre de $\pm30$ micromètres.

L'invention n'est pas limitée aux seuls exemples de réalisations explicitement décrits. En particulier en ce qui concerne la lame transparente 1, support des éléments optiques à structures diffractantes ou réfléchissants, celle-ci peut être disposée selon de nombreuses configurations par rapport aux cartes à circuits imprimés. Il suffit qu'elle soit en regard des émetteurs de lumière pour en capter le flux et en regard des détecteurs de lumière qui captent le flux lumineux émergeant de la lame après réflexions multiples le long des liaisons optiques établies.

## Revendications

1. Dispositif d'interconnexion optique pour un boîtier (Bt) contenant des cartes (Can à Can+4) de composants électroniques (CE), placées côte à côte, le dispositif permettant d'établir au moins une liaison par voie optique entre une première carte (Can) sur laquelle est implantée une source de lumière (En), émettant un faisceau divergent (Fe) suivant une première direction de propagation moyenne (Δe), et une seconde carte (Can+4) sur laquelle est implanté un détecteur de lumière (Rn+4), comportant une lame (1) à faces parallèles, en matériau transparent à ladite lumière, placée au regard de la source de lumière (En) et des éléments réflecteurs disposés sur les deux faces de la lame, caractérisé en ce qu'il comporte en outre les éléments optiques suivants: un premier élément optique (10) à structure diffractante sur une première face de la lame, opposée à la source de lumière (En), captant le faisceau divergent (Fn) et le réfléchissant sous la forme d'au moins un faisceau collimaté (Fc), de direction de propagation (Δ1) formant un angle déterminé (α) avec les faces de la lame (1), des éléments réflecteurs (11, 11') disposés sur les deux faces de la lame (1), captant et réfléchissant le faisceau collimaté (Fc) et un deuxième élément optique (12) à structure diffractante disposé sur la première face de la lame (1), captant après des réflexions successives à l'intérieur de la lame (1), sur les éléments réflecteurs (11, 11'), le faisceau collimaté (Fc) et le réfléchissant sous la forme d'un faisceau convergent (FR) suivant une deuxième direction (Δr) de propagation moyenne, ce faisceau (FR) étant capté par ledit détecteur de lumière (Rn+4) implanté sur la seconde carte (Can+4), de manière à former un chemin optique continu entre lesdites première (Can) et seconde (Can+4) cartes du boîtier (Bt).

2. Dispositif selon la revendication 1, caractérisé en ce que les éléments réflecteurs (11, 11') sont constitués par des plages métalliques déposées en alternance sur les deux faces de la lame (1).

3. Dispositif selon la revendication 1, caractérisé en ce que les éléments réflecteurs (11, 11') sont constitués par des métallisations de la surface des deux faces de la lame (1) à l'exception de zones sousjacentes aux éléments optiques à structure diffractante (11, 12).

4. Dispositif selon l'une quelconque des revendications 1 à 3, caractérisé en ce qu'il comprend en outre au moins un troisième élément optique (130, 131) à structure diffractante disposé sur une face de la lame (1), captant ledit faisceau collimaté (Fc) se propageant suivant une première direction comprise dans un premier plan et le réfléchissant sous la forme d'au moins un faisceau collimaté se propageant suivant une deuxième direction comprise dans un second plan, les deux plans formant entre eux un angle préétabli (γ').

5. Dispositif selon la revendication 4, caractérisé en ce que les éléments optiques (10, 12, 130, 131) à structure diffractante sont des films (Fi) disposés sur des zones déterminées de la lame (1) comportant un réseau optique constitués de microreliefs, métallisés (Me) pour former des réseaux de diffraction réfléchissants.

6. Dispositif selon la revendication 4, caractérisé en ce que les éléments optiques (10, 12, 130, 131) à structure diffractante sont des réseaux optiques constitués de microreliefs formés dans des zones superficielles de la lame (1) et métallisés pour former des réseaux de diffraction réfléchissant.

7. Dispositif selon l'une quelconque des revendications 5 ou 6, caractérisé en ce que les éléments (10, 12, 130, 131) à structure diffractante réfléchissent un faisceau incident sous la forme de plusieurs faisceaux collimatés ($F_{c1}$ à $F_{c4}$) de directions de propagation distinctes.

8. Dispositif selon l'une quelconque des revendications 4 ou 5, caractérisé en ce que les cartes ($Ca_n$ à $Ca_{n+4}$) dudit boîtier (Bt) étant toutes parallèles à un plan déterminé (xz), chaque premier et troisième éléments optiques à structure diffractantes est agencé sur la lame (1) de manière à réfléchir un faisceau incident en au moins un faisceau collimaté de direction de propagation comprise dans un plan formant un angle préétabli avec ledit plan déterminé.

9. Dispositif selon l'une quelconque des revendications 1 à 8, caractérisé en ce que chaque source de lumière ($E_n$) est une diode électroluminescente et en ce que chaque détecteur de lumière ($R_{N+4}$) est une diode de type PIN.

10. Procédé de fabrication d'un dispositif d'interconnexion optique suivant l'une quelconque des revendications 1 à 9, caractérisé en ce qu'il comprend une phase de création en des premières zones superficielles des faces de la lame (1) d'éléments optiques (10, 11, 130, 131) à structure diffractante et une phase de métallisation sélective de deuxièmes zones des faces de la lame (1) pour créer lesdits éléments réflecteurs (11, 11') de manière à former au moins une interconnexion optique de configuration préétablie ($I_1$ à $I_5$).

11. Procédé selon la revendication 10, caractérisé en ce que la phase de métallisation comprend une étape de métallisation uniforme des deux faces de la lame (1) à l'exception de zones des faces de la lame (1) sous-jacentes auxdites premières zones.

12. Procédé selon la revendication 11, caractérisé en ce que la phase de création d'éléments optiques (10, 12, 130, 131) à structure diffractante comprend une étape d'enregistrement holographique d'une figure de diffraction dans un film ($F_i$) de matériau photosensible déposé sur un support plan (Sb) en faisant interférer au sein du matériau un premier faisceau de lumière cohérente sous une première incidence et au moins un deuxième faisceau ($FS_2$) collimaté, de lumière cohérente, de direction de propagation ($\Delta$) formant un angle déterminé ($\theta$) avec ledit plan et une étape de développement et de fixage de la figure de diffraction de manière à obtenir un réseau optique constitué de microreliefs.

13. Procédé selon la revendication 12, caractérisé en ce qu'il comprend plusieurs expositions par des faisceaux collimatés ($FS_2$) de lumière cohérente de directions de propagations distinctes.

14. Procédé selon l'une quelconque des revendications 12 ou 13, caractérisé en ce que le premier faisceau est un faisceau divergent sous incidence normale au plan du support (Sb).

15. Procédé selon l'une quelconque des revendications 12 ou 13, caractérisé en ce que le premier faisceau est un faisceau collimaté ($FS_1$) de direction de propagation ($\Delta_1$) formant un angle ($\theta$) avec le plan du support (Sb) égal audit angle déterminé ($\theta$).

16. Procédé selon la revendication 12, caractérisé en ce que le matériau photosensible est de la gélatine bichromaté ou un photoresist.

17. Procédé selon la revendication 12, caractérisé en ce qu'il comprend une étape de transfert du réseau optique constitué de microreliefs sur une matrice (Ma) en matériau dur.

18. Procédé selon la revendication 17, caractérisé en ce que ledit matériau est du nickel.

19. Procédé selon l'une quelconque des revendications 17 ou 18, caractérisé en ce qu'il comprend de ladite matrice (Ma) sur un film ($F_i$) en matériau malléable de manière à y dupliquer ledit réseau optique constitués de microreliefs.

20. Procédé selon la revendication 19, caractérisé en ce que le matériau du film ($F_i$) est un matériau thermoplastique ou un polymère.

21. Procédé selon l'une quelconque des revendications 18 ou 19, caractérisé en ce que la lame (1) à faces parallèles est en matériau plastique et en ce qu'il comprend au moins une étape de pressage de ladite matrice (Ma) sur une des faces de la lame (1) pour y dupliquer, en une zone préétablie, le réseau optique constitué de microreliefs.

22. Procédé selon l'une quelconque des revendications 12 à 21, caractérisé en ce qu'il comprend une étape de métallisation (Me) superficielle du réseau constitué de microreliefs pour le rendre réfléchissant.

**Patentansprüche**

1. Vorrichtung zur gegenseitigen optischen Verbindung für ein Gehäuse (Bt), das Karten ($Ca_n$ à $Ca_{n+4}$) aus nebeneinander liegenden, elektronischen Bauteilen (CE) enthält, wobei die Vorrichtung es ermöglicht, über einen optischen Weg wenigstens eine Verbindung zwischen einer ersten Karte ($Ca_n$), auf welcher eine Lichtquelle ($E_n$) aufgesetzt ist, die entlang einer ersten mittleren Ausbreitungsrichtung ($\Delta_e$) ein divergierendes Bündel ($F_e$) erzeugt, und einer zweiten Karte ($Ca_{n+4}$) herzustellen, auf welcher ein Lichtdetektor ($R_{n+4}$) aufgesetzt ist, der eine Platte (1) mit zueinander parallelen Flächen, die aus einem für dieses Licht durchlässigen Material besteht und gegenüber der Lichtquelle ($E_n$) angeordnet ist, sowie reflektierende Elemente, welche beiderseits der Platte angeordnet sind, umfaßt, dadurch gekennzeichnet, daß sie ferner die folgenden optischen Elemente umfaßt: ein erstes optisches Element (10) mit einer beugenden Struktur auf einer ersten Fläche der Platte, die von der Lichtquelle ($E_n$) abgewandt ist, welche das reflektierende Bündel ($F_e$) aufnimmt und in der Form wenigstens eines kollimierten Bündels ($F_c$) einer Ausbreitungsrichtung ($\Delta_1$) reflektiert, die mit den Flächen der Platte (1) einen bestimmten Winkel ($\alpha$) bildet; reflek-

tierende Elemente (11, 11'), die auf beiden Flächen der Platte (1) angebracht sind und das kollimierte Bündel (Fc) auffangen und reflektieren; ein zweites optisches Element (12) mit einer beugenden Struktur, das auf der ersten Fläche der Platte (1) angeordnet ist, das nach aufeinanderfolgenden Reflexionen innerhalb der Platte (1) an den reflektierenden Elementen (11, 11') das kollimierte Bündel (Fe) auffängt und es in Form eines entlang einer zweiten mittleren Ausbreitungsrichtung ($\Delta_r$) reflektiert, wobei dieses Bündel (FR) durch den auf der zweiten Karte (Ca$_{n+4}$) angebrachten Lichtdetektor (R$_{n+4}$) aufgefangen wird, so daß ein kontinuierlicher optischer Weg zwischen der ersten Karte (Ca$_n$) und der zweiten Karte (Ca$_{n+4}$) des Gehäuses (Bt) gebildet wird.

2. Vorrichtung nach Anspruch 1, dadurch gekennzeichnet, daß die reflektierenden Elemente aus metallischen Bereichen bestehen, die abwechselnd auf beiden Flächen der Platte (1) aufgebracht sind.

3. Vorrichtung nach Anspruch 1, dadurch gekennzeichnet, daß die reflektierenden Elemente (11, 11') aus Metallisierungen der Oberfläche der beiden Flächen der Platte (1) bestehen, ausgenommen die Bereiche, die sich unter den optischen Elementen (11, 12) mit beugender Struktur befinden.

4. Vorrichtung nach einem der Ansprüche 1 bis 3, dadurch gekennzeichnet, daß sie ferner wenigstens ein drittes optisches Element (130, 131) mit beugender Struktur umfaßt, das auf einer Fläche der Platte (1) angebracht ist und das kollimierte Bündel (Fc) auffängt, welches sich entlang einer ersten, in einer ersten Ebene enthaltenen Richtung ausbreitet, und es in Form von wenigstens eines kollimierten Bündels reflektiert, das sich entlang einer zweiten, in einer zweiten Ebene enthaltenen Richtung ausbreitet, wobei die beiden Ebenen miteinander einen vorbestimmten Winkel ($\tau'$) bilden.

5. Vorrichtung nach Anspruch 4, dadurch gekennzeichnet, daß die optischen Elemente (10, 12, 130, 131) mit beugender Struktur Filme (Fi) sind, welche auf bestimmten Zonen der Platte (1) angeordnet sind, die ein optisches Netz aus Mikroreliefs (Me) umfaßt, welche metallisiert sind, um reflektierende Beugungsgitter zu bilden.

6. Vorrichtung nach Anspruch 4, dadurch gekennzeichnet, daß die optischen Elemente (10, 12, 130, 131) mit beugender Struktur optische Gitter sind, welche aus in den Oberflächenzonen der Platte (1) gebildeten Mikroreliefs bestehen und metallisiert sind, um reflektierende Beugungsgitter zu bilden.

7. Vorrichtung nach Anspruch 5 oder 6, dadurch gekennzeichnet, daß die Elemente (10, 12, 130, 131) mit beugender Struktur ein ankommendes Bündel in Form von mehreren kollimierten Bündeln (Fc$_1$ bis Fc$_4$) mit getrennten Ausbreitungsrichtungen reflektieren.

8. Vorrichtung nach Anspruch 4 oder 5, dadurch gekennzeichnet, daß - da die Karten (Ca$_n$ bis (Ca$_{n+4}$) des Gehäuses (1) zu einer bestimmten Ebene (xz) parallel sind - jedes erste optische Element sowie jedes dritte optische Element mit beugender Struktur so auf der Platte (1) angeordnet ist, daß es ein ankommendes Bündel in wenigstens einem kollimierten Bündel mit einer Ausbreitungsrichtung reflektiert, die in einer Ebene enthalten ist, welche mit der bestimmten Ebene einen vorbestimmten Winkel bildet.

9. Vorrichtung nach einem der Ansprüche 1 bis 8, dadurch gekennzeichnet, daß jede Lichtquelle (En) eine Leuchtdiode ist und daß jeder Lichtdetektor (R$_{n+4}$) eine PIN-Diode ist.

10. Verfahren zur Herstellung einer Vorrichtung zur optischen Verbindung nach einem der Ansprüche 1 bis 9, dadurch gekennzeichnet, daß es eine Phase zur Bildung von optischen Elementen (10, 11, 130, 131) mit beugender Struktur auf ersten Oberflächenzonen der Flächen der Platte (1) sowie eine Phase zur selektiven Metallisierung von zweiten Zonen der Fläche der Platte (1) umfaßt, um die reflektierenden Elemente (11, 11') zu bilden, so daß wenigstens eine optische Verbindung (1$_1$ bis 1$_5$) einer vorbestimmten Konfiguration gebildet wird.

11. Verfahren nach Anspruch 10, dadurch gekennzeichnet, daß die Metallisierungsphase einen Schritt zur gleichmäßigen Metallisierung beider Flächen der Platte (1) umfaßt, die Zonen der Flächen der Platte (1) ausgenommen, die sich unter den ersten Zonen befinden.

12. Verfahren nach Anspruch 11, dadurch gekennzeichnet, daß die Phase zur Bildung der optischen Elemente (10, 12, 130, 131) mit beugender Struktur einen Schritt zur holographischen Aufzeichnung einer Beugungsfigur in einem Film (Fi) umfaßt, der aus einem lichtempfindlichen Material besteht und auf einen ebenen Träger (Sb) aufgebracht ist, wobei innerhalb des Materials ein erstes Bündel aus kohärentem Licht unter einem ersten Einfallswinkel mit wenigstens einem zweiten kollimierten Bündel (FS$_2$) kohärenten Lichtes, dessen Ausbreitungsrichtung ($\Delta$) mit der Ebene einen bestimmten Winkel ($\Theta$) bildet, zur Interferenz gebracht wird, sowie einen Schritt zur Entwicklung und Fixierung der Beugungsfigur umfaßt, so daß ein aus Mikroreliefs bestehendes optisches Gitter erhalten wird.

13. Verfahren nach Anspruch 12, dadurch gekennzeichnet, daß es mehrere Belichtungen durch kollimierte Bündel (FS$_2$) eines kohärenten Lichts mit getrennten Ausbreitungsrichtungen umfaßt.

14. Verfahren nach Anspruch 12 oder 13, dadurch gekennzeichnet, daß das erste Bündel ein unter senkrechtem Einfall zu der Ebene des Trägers (Sb) divergierendes Bündel ist.

15. Verfahren nach Anspruch 12 oder 13, dadurch gekennzeichnet, daß das erste Bündel ein kollimiertes Bündel (FS$_1$) einer Ausbreitungsrichtung ($\Delta_1$) ist, die mit der Ebene des Trägers (Sb) einen Winkel ($\Theta$) bildet, der dem bestimmten Winkel ($\Theta$) entspricht.

16. Verfahren nach Anspruch 12, dadurch gekennzeichnet, daß das lichtempfihdliche Material eine Bichromat-Gelatine oder ein Photoresist ist.

17. Verfahren nach Anspruch 12, dadurch gekennzeichnet, daß es einen Schritt zur Übertragung des aus Mikroreliefs bestehenden optischen Gitters auf eine Matrix (Ma) aus einem harten Material umfaßt.

18. Verfahren nach Anspruch 17, dadurch gekennzeichnet, daß das Material Nickel ist.

19. Verfahren nach Anspruch 17 oder 18, dadurch gekennzeichnet, daß es die Übertragung der Matrix (Ma) auf einen Film (Fi) aus einem geschmeidigen Material umfaßt, so daß man das aus Mikroreliefs bestehende optische Gitter darauf dupliziert.

20. Verfahren nach Anspruch 19, dadurch gekennzeichnet, daß das Filmmaterial ein Thermoplast oder ein Polymer ist.

21. Verfahren nach Anspruch 18 oder 19, dadurch gekennzeichnet, daß die Platte (1) mit zueinander parallelen Flächen aus einem plastischen Material besteht und wenigstens einen Schritt zum Pressen der Matrix (Ma) auf eine der Flächen der Platte (1) umfaßt, um in einer vorbestimmten Zone das aus Mikroreliefs bestehende optische Gitter darauf zu duplizieren.

22. Verfahren nach einem der Ansprüche 12 bis 21, dadurch gekennzeichnet, daß es einen Schritt zur oberflächlichen Metallisierung (Me) des aus Mikroreliefs bestehenden Gitters umfaßt, damit es reflektierende Eigenschaften annimmt.

## Claims

1. An optical interconnecting device for a box (Bt) containing cards (Ca_n to Ca_{n+4}) for electronic components (CE), placed sided by side, said device making it possible to establish at least one connection by an optical path between a first card (Ca_n) on which a source of light (E_n) is attached emitting a diverging beam)(F_e) along a first direction of mean propagation ($\Delta$e) and a second card (Ca_{n+4}) bearing a light detector (R_{n+4}), comprising a sheet (1) with parallel faces, of material transparent to the said light, placed opposite the source (E_n) of light, and reflecting elements placed on the two faces of the sheet, characterized in that it comprises furthermore the following optical elements: a first optical element (10) with a diffracting structure on a first face of the sheet, opposite to the source (E_n) of light, receiving the diverging beam (F_e) and reflecting it in the form of at least one collimated beam (Fc), with a direction ($\Delta_1$) of propagation forming a given angle (a) with the faces of the sheet (1), reflecting elements (11 and 11') on the two sides of the sheet, receiving and reflecting the collimated beam (Fc) and a second optical element (12) with a diffracting structure placed on the first face of the sheet (1), receiving after successive reflection within the sheet (1), on the reflecting elements (11 and 11`), the collimated beam (Fc) and reflecting the sane in the form of a converging beam (F_R) in accordance with a second direction ($\alpha$r) of mean propagation, the said beam (F_R) being received by the said light detector (R_{n+4}) attached to the second card (Ca_{n+4}) in such a manner as to form a continuous optical path between the said first (Ca_n) and second Ca_{n+4} cards of the box (Bt).

2. The device as claimed in claim 1, characterized in that the reflecting elements (11 and 11') are constituted by metallic coatings placed in an alternating fashion on the two faces of the sheet (1).

3. The device as claimed in claim 1, characterized in that the reflecting elements (11 and 11`) are constituted by metallized areas on the surface of the two faces of the sheet (1) with the exclusion of subjacent zones under the optical elements with a diffracting structure (11 and 12).

4. The device as claimed in any one of the claims 1 through 3, characterized in that it furthermore comprises at least a third optical element (130 and 131) with a diffracting structure placed on one face of the sheet (1), receiving the said collimated beam (Fc) which is propagated in a first direction comprised in a first plane and reflecting the same in the form of at least one collimated beam propagated in a second direction comprised in a second plane, the two planes forming an predetermined angle ($\gamma$) between them.

5. The device as claimed in claim 4, characterized in that the optical elements (10, 12, 130 and 131) with a diffracting structure are films (F_i) placed on given zones of the sheet (1) comprising an optical network constituted by microreliefs, which are metallized (M_e) in order to form reflective diffracting networks.

6. The device as claimed in claim 4, characterized in that the optical elements (10, 12, 130 and 131) with a diffracting structure are optical networks constituted by microreliefs formed in the superficial zones of the sheet (1) and metallized in order to form networks with a reflecting diffracting effect.

7. The device as claimed in claim 5 or in claim 6, characterized in that the elements (10, 12, 130 and 131) with a diffracting structure reflect an incident beam in the form of several collimated beams (Fc_1 to Fc_4) with distinct directions of propagation.

8. The device as claimed in claim 4 or in claim 5, characterized in that the cards (Ca_n to Ca_{n+4}) of the said bow (Bt) are all parallel to a determined plane (xz), and each first and third optical element with a diffracting structure is arranged on the sheet (1) in such a manner as to reflect an incident beam as at least one collimated beam with a direction of propagation comprised in a plane forming a given angle with the said given plane.

9. The device as claimed in any one of the claims 1 through 8, characterized in that each source (E_n) of light is an LED and in that each light detector (R_{n+4}) is a PIN diode.

10. A process for the manufacture of an optical interconnecting device as claimed in any one of the preceding claims 1 through 9, characterized in that it comprises a phase for the creation of first superficial zones on the faces of the sheet (1) of optical elements (10, 11, 130 and 131) with a diffracting structure and a phase of selective metallization of second zones of the faces of the sheet (1) in order to create the said reflecting elements (11 and 11') in such a manner as to form at least one optical interconnection with a given configuration (1_1 to 1_5).

11. The process as claimed in claim 10, characterized in that the metallization phase comprises a stage of uniform metallization of the two faces of the sheet (1) with the exception of the faces zones of the sheet (1) underlying the said first zones.

12. The process as claimed in claim 11, characterized in that the phase for the creation of optical elements (10, 12, 130 and 131) with a diffracting structure comprises a stage of holographic recording of a diffraction figure in a film (Fi) of photosensitve material placed on a flat support (Sb) by causing within the material interference between a first beam of coherent light at a first incidence and at least one second collimated beam (FS2) of coherent light, with a propagation direction (Δ) at a given angle (Θ) to the said plane and a stage of development and of fixing the diffraction figures in such a manner as to obtain an optical network constituted by microreliefs.

13. The process as claimed in claim 12, characterized in that it comprises several exposures to collimated beams (FS2) of coherent light with distinct propagation directions.

14. The process as claimed in claim 12 or in claim 13, characterized in that the first beam is a diverging beam with normal incidence to the support plane (Sb).

15. The process as claimed in claim 12 or claim 13, characterized in that the first beam is a collimated beam (FS1) with a direction (Δ1) of propagation at an angle (Θ) to the support plane (Sb) equal to the said given angle (Θ).

16. The process as claimed in claim 12 characterized in that the photosensitive material is gelatine bichromate or a photoresist.

17. The process as claimed in claim 12, characterized in that it comprises a stage of transfer of the optical network made up of microreliefs onto a matrix (Ma) of hard material.

18. The process as claimed in claim 17, characterized in that the said material is nickel.

19. The process as claimed in claim 17 or in claim 18, characterized in that it comprises such matrix (Ma) on a film (Fi) of malleable material in such a manner as to duplicate the said optical network made up of microreliefs.

20. The process as claimed in claim 19, characterized in that the material of the film (Fi) is a thermoplastic material or a polymer.

21. The process as claimed in claim 18 or claim 19, characterized in that the sheet (1) with parallel faces is made of plastic material and in that it comprises at least one stage of pressing of the said matrix (Ma) on one of the faces of the sheet (1) in order to duplicate, in a given zone, the optical network made up of microreliefs.

22. The process as claimed in any one of the claims 12 through 21, characterized in that it comprises a superficial metallizing stage (Me) on the network made up of microreliefs in order to render it reflecting.

EP 0 196 933 B1

# FIG_1

# FIG_2

# FIG_3

EP 0 196 933 B1

FIG_4

FIG_5

FIG_6

FIG_7

FIG_8

FIG_9

EP 0 196 933 B1

# FIG_10

# FIG_11

# FIG_12

# FIG_13

# FIG_14

# FIG_15